# EUROPEAN PATENT APPLICATION

(11) **EP 4 358 153 A1**
(43) Date of publication of application: **24.04.2024**
(21) Application number: 23203441.3
(22) Date of filing: 13.10.2023
(51) Int. Cl.: H01L 29/66, H01L 29/78

(54) **SEMICONDUCTOR TRANSISTOR**

(30) Priority: 17.10.2022 US 202263416616 P; 09.11.2022 US 202217984225
(71) Applicant: Invention And Collaboration Laboratory Pte. Ltd., Singapore 068914 (SG)
(72) Inventor: Lu, Chao-Chun, Taipei City 106 (TW)
(74) Representative: Straus, Alexander

(57) **Abstract**

The present invention provides a fin structure transistor with precise and well-controlled geometries. Such fin structure transistor includes a semiconductor substrate with an original surface and an active region formed based on the semiconductor substrate, the active region has a fin structure. A shallow trench isolation region surrounds the active region and a gate structure of the transistor crosses over the fin structure and covers a first portion of the shallow trench isolation region. Wherein the fin structure includes a fin body covered by the gate structure and a fin base portion of which is not covered by the gate structure, and a step-like transition is between the fin body and the fin base.

## Description

### Field of the Invention

The present invention relates to a semiconductor transistor according to claim 1.

### Background of the Invention

The most widely used semiconductor MOSFET structure of various process nodes from 20nm down to 5nm is so-called Fin Field-Effect Transistor (FinFET) or Tride-gate FET. This kind of 3D FET enables effective miniaturization of its planar area and enhances its performance, which are demanded by fulfilling Moore's Law. However, Table 1 shows state-of-the-art transistor density (unit: Million Transistor per mm2; MTr/mm2) of different manufacture technologies and our calculation based on the transistor density of Manufacture A's 16nm node (28.88 MTr/mm2) if Moore's law is obeyed, and it is clear that the increased number of transistors per unit area cannot meet the Moore's Law demand while the process nodes are scaled from 16nm to 3nm at all. For example, in Table 1 it is found that in a process node of 7nm and 5nm, the ideal target of the number of transistors is 150.88 MTr/mm2 and 295.73 MTr/mm2, respectively, but with the most of the state-of-the-art fabrication capabilities the realistic number of transistors per mm^2 is much lower than it should be.

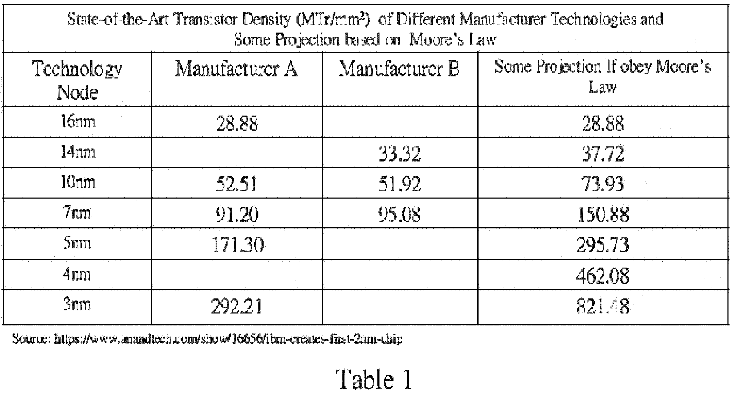

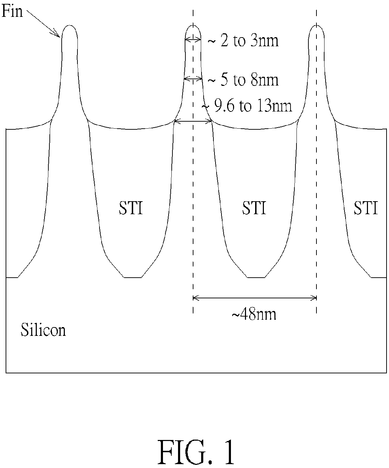

One reason of limiting the effectiveness of scaling the FinFET's planar area is due to scaling the pitch (Fin width + Fin-to-Fin space) of the Fin Body. For example, a cross-section dimension of state-of-the-art technology node 14 nm FinFET is shown in FIG. 1, the Fin Body has a strange sharp shape: a small top area (~2 to 3nm), a wide body width in the middle (~5 to 8nm), a wider at the bottom of the Fin Body (~9 to 13nm) where is leveled with the bottom of the Gate, and a very wide distance at the bottom of the STI (Shallow Trench Isolation, usually of Oxide material) between two neighboring FinFET. So the pitch could be ~48 nm depending on individual manufacture/factory capabilities, about 3.5F where F represents the minimum feature size or the process node declared by the individual manufacture. Some weaknesses are revealed here:
(1) The most important parameter affecting the FinFET performance and quality is surely the width of the Fin Body, but its variation is large and hard to control precisely as shown in the state-of-the-art FinFET technology.
(2) The shape of this Fin "Hill" is very difficult to maintain its consistency and to minimize its variations.
(3) Due to this "Hill" both the width and the depth of the STI is hard to be optimized.
(4) The pitch occupies at least >3F to 5F, which hurts scaling of the transistor's planar area.
(5) The key parameter for performance and leakage is affected by the shape and size of this sharp shape Fin and hard to minimize their variations.
(6) The Fin Body could be easily bent or fall off as the dimension is getting narrower due to scaling, or the number of this kind of "Hill" Fin is increasing significantly as more and more FinFETs must be fabricated on a larger and complex die.

Therefore, how to solve the aforesaid problems in order to fit demands from the Moore's Law of more transistors per unit area and lower cost per transistor is a challenge.

### Summary of the Invention

The present invention aims at providing a semiconductor transistor that can make a transistor have precise and well-controlled geometries (such as, shapes or dimensions of Fin structure, Fin width, source/drain structure, and/or metal plug connecting to source/drain structure) so as to reduce an area of the transistor and prevent collapse of the Fin structure.

This is achieved by a semiconductor transistor according to claim 1. The dependent claims pertain to corresponding further developments and improvements.

As will be seen more clearly from the detailed description following below, the claimed semiconductor transistor includes a semiconductor substrate with an original surface, an active region, a shallow trench isolation region, a gate structure, a first conductive structure and a second conductive structure, and a spacer. The active region is formed based on the semiconductor substrate. The active region has a fin structure. The shallow trench isolation region surrounds the active region. The gate structure of the transistor crosses over the fin structure. The spacer is contacted to a sidewall of the gate structure and over the fin structure. A width of the fin structure under the spacer is wider than that of the fin structure under the gate structure, or the fin structure has a perpendicular profile along a direction substantially perpendicular to the original surface, wherein the perpendicular profile of the fin structure provides a first non-gradual transition or step-like transition.

This invention discloses a new Fin structure transistor, and introduces its inventive principle to improve or eliminate the above-mentioned weaknesses to achieve a new 3D FET structure which can have precise and well-controlled geometries (such as, shapes or dimensions of Fin structure, Fin width, Source/Drain structure, and/or metal plug connecting to Source/Drain structure), thus reducing the planar of the transistor so as to getting closer to the demands from the Moore's Law of more transistors per unit area and lower cost per transistor.

According to one aspect of the present invention, the first conductive structure is limited by the shallow trench isolation region, and a width of the first conductive structure is wider than that of the fin structure under the gate structure.

According to one aspect of the present invention, the fin structure includes a fin body and a fin base, the fin structure has a perpendicular profile along a direction substantially perpendicular to the original surface, and the perpendicular profile includes a step-like transition between the fin body and the fin base.

According to one aspect of the present invention, the fin structure has a lateral profile along a direction substantially parallel to the original surface. The lateral profile of the fin structure provides another step-like transition.

According to one aspect of the present invention, the first conductive structure is contacted to a first end of the fin structure, the second conductive structure is contacted to a second end of the fin structure, and the first conductive structure and the second conductive structure are independent from the Fin structure.

According to one aspect of the present invention, a bottom of the gate structure over the shallow trench isolation region is lower than that of the first conductive structure and/or the second conductive structure.

According to one aspect of the present invention, at least two sides of the first conductive structure or the second conductive structure are contacted to a metal-containing region.

According to one aspect of the present invention, wherein the fin structure includes a fin body covered by the gate structure and a fin base portion of which is not covered by the gate structure, and the first non-gradual transition or step-like transition is between the fin body and the fin base.

According to one aspect of the present invention, a top surface of a portion of the shallow trench isolation region covered by the gate structure is lower than that of other portion of the shallow trench isolation region not covered by the gate structure.

According to one aspect of the present invention, the fin structure has a lateral profile along a direction substantially along to the original surface, wherein the lateral profile of the Fin structure provides a second non-gradual transition or step-like transition.

According to one aspect of the present invention, the second non-gradual transition or step-like transition is between the gate structure and the first conductive structure.

According to one aspect of the present invention, the lateral profile of the fin structure further provides a third non-gradual transition or step-like transition which is between the gate structure and the second conductive structure.

According to one aspect of the present invention, the first conductive structure and/or the second conductive structure is limited by the shallow trench isolation region.

According to one aspect of the present invention, the first conductive structure is contacted to a first end of the fin structure, the second conductive structure is contacted to a second end of the fin structure, and the first conductive structure and the second conductive structure are independent from the fin structure.

According to one aspect of the present invention, a bottom of the gate structure over the shallow trench isolation region is lower than that of the first conductive structure and/or the second conductive structure.

According to one aspect of the present invention, at least two sides (such as top surface and one sidewall) of the first conductive structure are contacted to a metal-containing region.

According to one aspect of the present invention, the perpendicular profile of the fin structure covered by the gate structure includes two non-gradual transition or step-like transition.

### Brief Description of the Drawings

The present invention is further illustrated by way of example, taking reference to the accompanying drawings thereof:
FIG. 1 is a diagram illustrating a cross section view of a conventional FinFET based on technology node 14nm,
FIG. 2A is a flowchart illustrating a manufacturing method of a Fin structure transistor according to one embodiment of the present invention,
FIG. 2B, FIG. 2C, FIG. 2D, and FIG. 2E are diagrams illustrating FIG. 2A,
FIG. 3 is a diagram illustrating the Pad-Oxide layer being formed, the Pad-Nitride layer being deposited, the preliminary trench being formed by the first dig-etching process, and Oxide spacer layer OS1 and Nitride spacer layer NS1 being formed,
FIG. 3-1 is a cross section view along the Y-direction cutline of the temporary structure in FIG. 3,
FIG. 4 is a diagram illustrating the semiconductor material being further removed by the second dig-etching process,
FIG. 4-1 is a cross section view along the Y-direction cutline of the temporary structure in FIG. 4,
FIG. 4-2 is a cross section view along the Y-direction cutline of another temporary structure according to other embodiment,
FIG. 5 is a diagram illustrating the shallow trench isolation (STI) region being formed,
FIG. 5-1 is a cross section view along the Y-direction cutline of the temporary structure in FIG. 5,
FIG. 6 is a diagram illustrating the gate area or gate region across the Fin structure being formed to reveal sidewalls of the Fin structure,
FIG. 6-1 is a cross section view along the Y-direction cutline of the temporary structure in FIG. 6,
FIG. 7 is a diagram illustrating the Fin Body and Fin Base being thinned or shaped in the gate region,
FIG. 7-1 is a cross section view along the Y-direction cutline of the temporary structure in FIG. 7,
FIG. 8 is a diagram illustrating the pad Oxide and pad Nitride being removed in the gate region,
FIG. 8-1 is a cross section view along the Y-direction cutline of the temporary structure in FIG. 8,
FIG. 9 is a diagram illustrating the gate dielectric material and gate conductive material being formed, and the composite cap layer being deposited,
FIG. 9-1 is a cross section view along the Y-direction cutline of the temporary structure in FIG. 9,
FIG. 10, FIG. 11, FIG. 12, FIG. 13, FIG. 14, FIG. 15, FIG. 16, FIG. 17, FIG. 17-1 are diagrams illustrating the source and drain structures being formed,
FIG. 10A, FIG. 11A, FIG. 11B, FIG. 12A, FIG. 13A, FIG. 14A, FIG. 15A, FIG. 16A, FIG. 17A are diagrams illustrating the source and drain structures being formed according to another embodiment of the present invention, wherein FIG. 11B which is a simulation result to form the spacer on the edge of the Gate structure, and
FIG. 17B is a diagram illustrating the source and drain structures being formed according to another embodiment of the present invention.

### Detailed Description

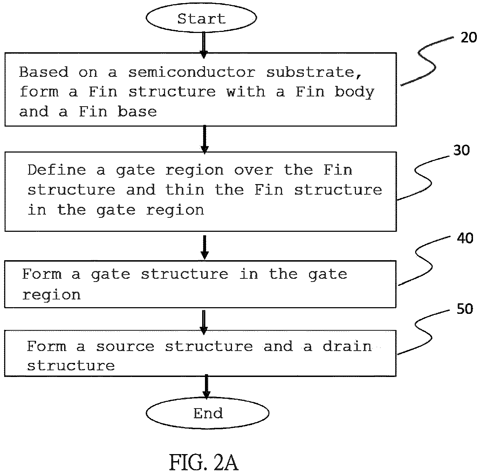

Please refer to FIG. 2A. FIG. 2A is a flowchart illustrating a manufacturing method of a Fin structure transistor (such as, FinFET or Tride-gate FET) according to one embodiment of the present invention, and the manufacturing method of the Fin structure transistor described herein with precise and well-controlled geometries (such as the Fin structure transistor with a smaller Fin Pitch and a more precise/well controlled Fin width), thus reducing the planar of the transistor and preventing the collapse of the Fin structure. Hereinafter, the proposed new FinFET or Tri-gate FET according to one embodiment of the present invention is named as RB-FinFET or RB-Tri-gate FET (RB: Rectangular Body) which can be achieved by an exemplary processing method described in the following. Detailed steps are as follows:

| | |
|---|---|
| Step 10: | Start. |
| Step 20: | Based on a semiconductor substrate, form a Fin structure with a Fin body and a Fin base. |
| Step 30: | Define a gate region over the Fin structure and thin the Fin structure in the gate region. |
| Step 40: | Form a gate structure in the gate region. |
| Step 50: | Form a source structure and a drain structure. |
| Step 60: | End. |

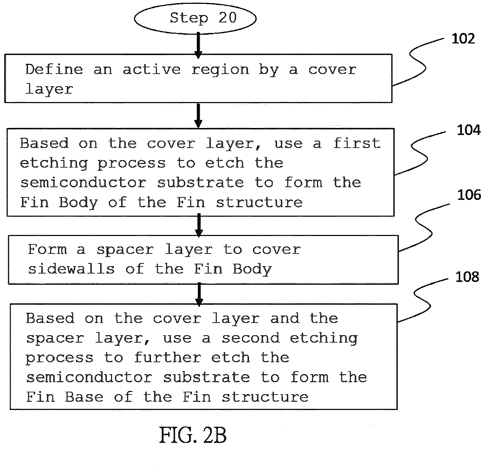

Please refer to FIG. 2B and FIGS. 3, 3-1, 4, and 4-1, Step 20 could include:

| | |
|---|---|
| Step 102: | Define an active region by a cover layer (such as a composite layer with a Oxide layer and a Nitride layer). |
| Step 104: | Based on the cover layer, use a first etching process to etch the semiconductor substrate to form the Fin Body of the Fin structure. |
| Step 106: | Form a spacer layer (such as a composite layer with a Oxide layer and a Nitride layer) to cover sidewalls of the Fin Body. |
| Step 108: | Based on the cover layer and the spacer layer, use a second etching process to further etch the semiconductor substrate to form the Fin Base of the Fin structure. |

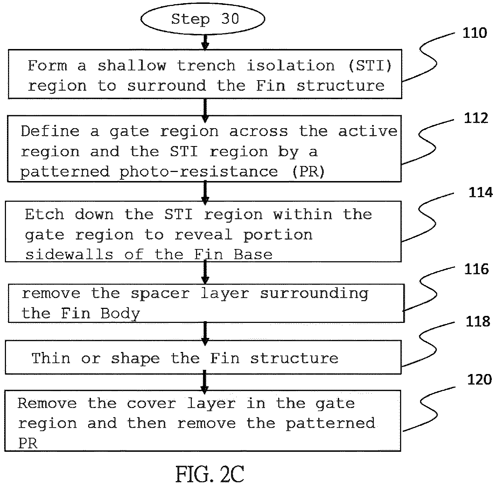

Then, please refer to FIG. 2C and FIGS. 5 to 8-1, Step 30 could include:

| | |
|---|---|
| Step 110: | Form a shallow trench isolation (STI) region to surround the Fin structure, wherein a top surface of the STI region is higher than an original surface (OSS) of the semiconductor substrate. |
| Step 112: | Define a gate region across the active region and the STI region by a patterned photo-resistance. |
| Step 114: | Etch down the STI region within the gate region to reveal sidewalls of the Fin base. |
| Step 116: | Remove the spacer layer surrounding the Fin body, such that sidewalls of the Fin body are revealed. |
| Step 118: | Thin the Fin body and the Fin base in the gate region. |
| Step 120: | Remove the cover layer in the gate region and then remove the patterned photo-resistance. |

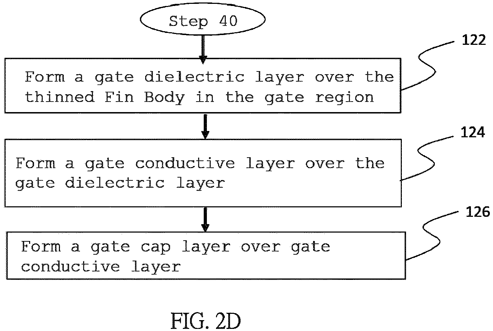

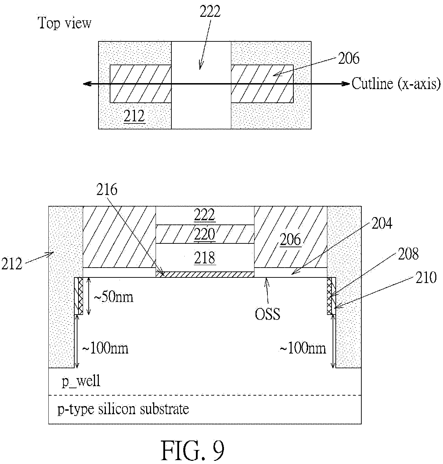

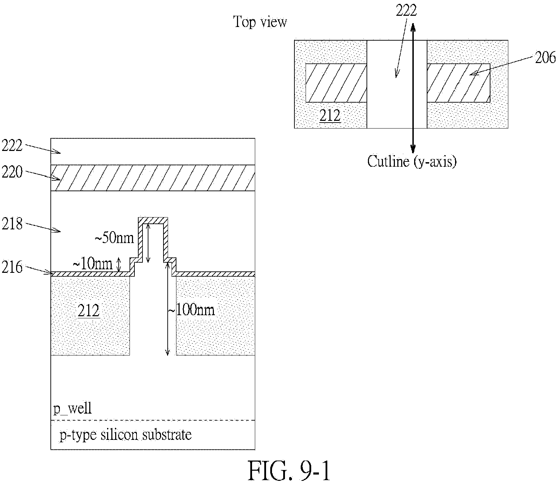

Please refer to FIG. 2D, FIG. 9 and 9-1, Step 40 could include:

| | |
|---|---|
| Step 122: | Form a gate dielectric layer over the thinned Fin Body in the gate region. |
| Step 124: | Form a gate conductive layer over the gate dielectric layer. |
| Step 126: | Form a gate cap layer over gate conductive layer. |

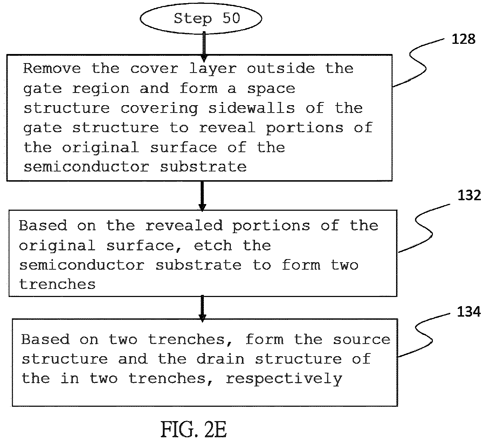

Please refer to FIG. 2E, FIG. 10 to FIG. 17-1, Step 50 could include:

| | |
|---|---|
| Step 128: | Remove the cover layer outside the gate region and form a space structure covering sidewalls of the gate structure to reveal portions of the original surface of the semiconductor substrate. |
| Step 130: | Based on the revealed portions of the original surface, etch the semiconductor substrate to form two trenches. |
| Step 132: | Based on two trenches, form the source structure and the drain structure of the in two trenches, respectively. |

Start with the well-designed doped p-type well 202, wherein the p-type well 202 is installed in a p-type substrate 200 (wherein in another embodiment of the present invention, could start with the p-type substrate 200, rather than starting with the p-type well 202), wherein in one example the p-type substrate 200 has concentration close to 5×10^15 dopants/cm^3, and the p-type substrate voltage (which is usually Grounded, i.e. 0 V) could be supplied across most of the body of the FinFET.

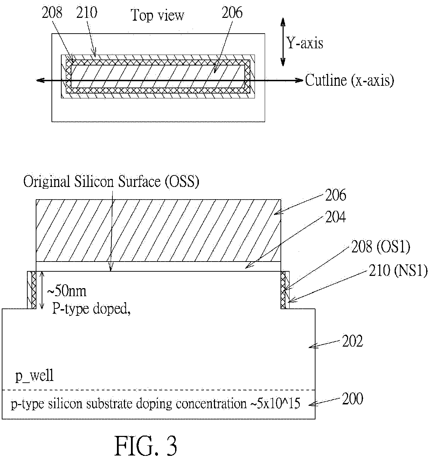

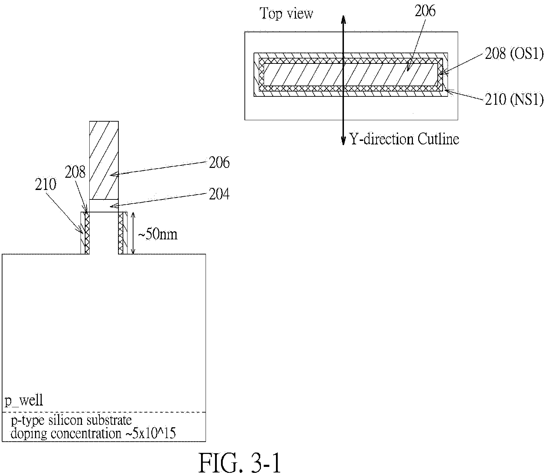

In step 102, as shown in FIG. 3, grow a layer of thermal Oxide over the Silicon wafer to form a Pad-Oxide layer 204 on the OSS (Original Silicon Surface) and then deposit a layer of Pad-Nitride layer 206. Use the photolithographic technique to define active regions in which the Fin Body of the future transistor will be allocated. Thereafter, use an anisotropic etching technique to remove the Pad-Nitride layer 206 and the Pad-Oxide layer 204 out of the active regions. Then, in step 104, use an anisotropic etching (such as Reactive Ion Etching, RIE) to remove or dig the Silicon and to make trenches in the Silicon wafer with a depth about 50nm. In one embodiment, the width of the Pad-Nitride layer 206 on the active region along the Y-direction is around 9nm in a process node of F=5nm and the space between two active regions is 9nm, which results in a pitch of 18nm = 3.6F. In another embodiment, the width of Pad-Nitride along the Y-direction could be 10nm in a process node of F=10nm and the space between two active regions is 10nm, which results in a pitch of 20nm = 2F. The aforesaid numbers are listed for illustration purpose and the present invention is not limited to those dimensions.

Then, in step 106, along the exposed Silicon sidewalls a thermal oxidation is performed to form a thin Oxide spacer layer 208 (OS-1) vertically outside the Fin Body, and form a vertical Nitride spacer layer 210 (NS-1) outside such vertical Oxide spacer layer 208 (FIG. 3). The cross section view along the Y-direction cutline of this temporary structure is shown in FIG. 3-1. The thin Oxide spacer layer 208 and the Nitride spacer layer 210 could protect the structure of the Fin Body. It is noticed that in one example the thin Oxide spacer layer 208 is very thin and it barely affect the width of the Fin width. Moreover, in another example, the Oxide spacer layer 208 and the Nitride spacer layer 210 may form a solid wall to clamp the active region or the Fin structure, especially sidewalls of the Fin structure.

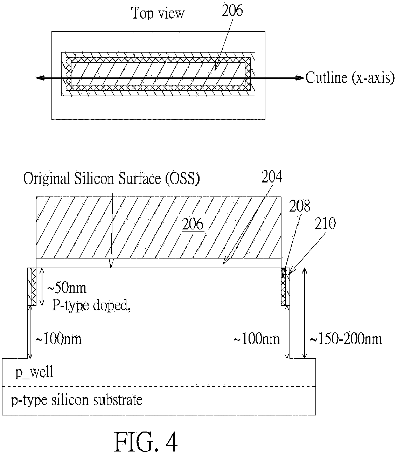

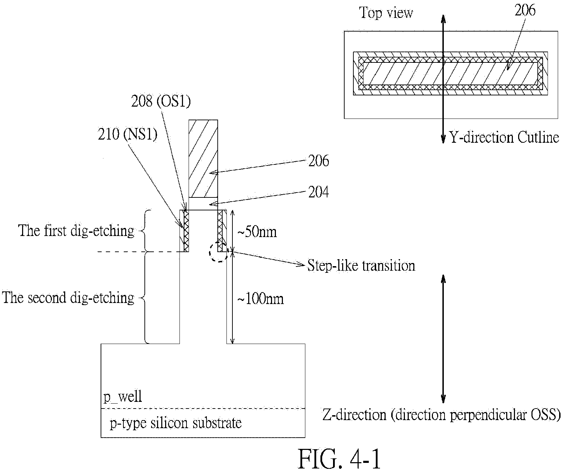

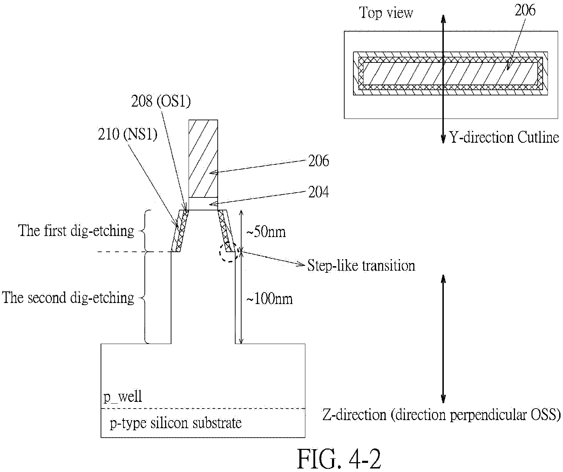

In step 108, based on the Pad-Nitride layer 206 as a mask and the Nitride spacer 210, use an anisotropic etching technique to remove or dig Silicon again(such as 100nm depth of Silicon) to form a deeper trench, such that the depth of the deeper trench from the top of the OSS is around 150-200 nm, as shown in FIG. 4, and the cross section view along the Y-direction cutline of this temporary structure is shown in FIG. 4-1. As shown in FIG. 4-1, due to the existence of the Oxide spacer layer 208 and the Nitride spacer 210, the perpendicular profile (along a direction (Z-axis) substantially perpendicular to the original surface) of the invented Fin structure has a step-like transition between the portion of the Fin structure formed by the first dig-etching step and the portion of the Fin structure formed by the second dig-etching step. It is possible that the perpendicular profile of the invented Fin structure has a non-gradual transition between the portion of the Fin structure formed by the first dig-etching step and the portion of the Fin structure formed by the second dig-etching step.

Of course, the shape of the Fin structure after the first dig-etching step and the second dig-etching step is not limited to the structure shown in FIG. 4 and FIG. 4-1, other desired shape could also be performed by available etching processes. For example, FIG. 4-2 shows a cross section view along the Y-direction cutline of another temporary structure according to other embodiment of the present invention, wherein the fin shape caused by the first dig-etching process is a trapezoid or trapezoid-like shape.

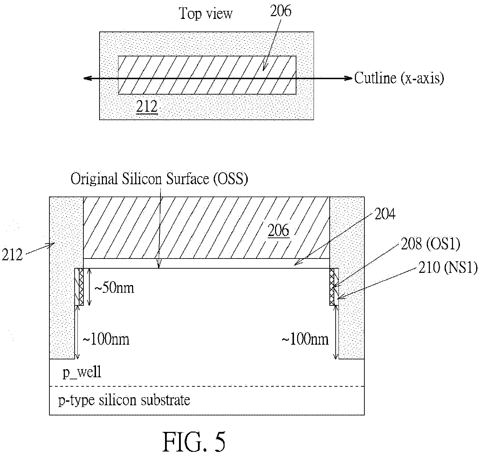

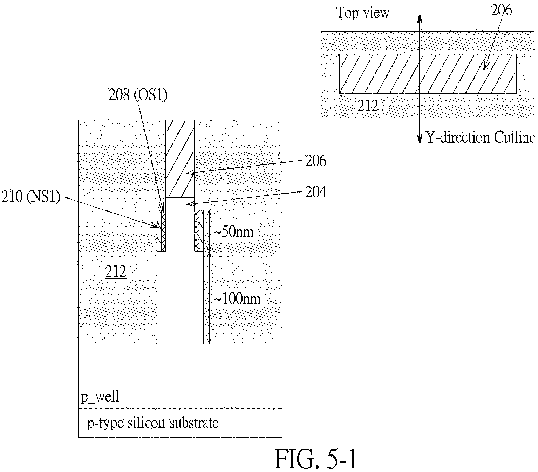

Furthermore, in step 110, deposit a layer of Oxide thick enough to fill in the trenches over the top of the Pad-Nitride layer 206. Use a CMP (Chemical Mechanical Polishing) technique to remove the extra deposited Oxide over the surface of the Pad-Nitride layer 206 to form regions called Shallow Trench Isolation (STI) region 212, as shown in FIG. 5. The cross section view along the Y-direction cutline of this temporary structure is shown in FIG. 5-1. The STI region 212 could clamp the Fin structure and prevent the Fin structure from collapse in the following processes.

Therefore, through the Oxide spacer layer 208, the Nitride spacer 210 and the raised STI Oxide 212, the Fin structure formed by the first dig-etching step and the second dig-etching step (referring to FIG. 4-1) are well protected. In the conventional FinFET, the Fin structure is formed just by one etching step and the Fin Body looks like a sharp shape with gradual transition in the vertical profile (FIG. 1), the width of the Fin Body is difficult to control and the Fin Body is easily collapsed. By the multiple Silicon-etching steps and the protecting processes according to the present invention, the collapse of the Fin structure during the etching process could be prevented, and the shape of Fin structure could be rectangular-like or other preferable shape, especially the portion of the Fin structure formed by the first etching step.

Described in the following is how to form the RB structure with a narrow Fin Body. In step 112, use a photolithographic technique to define the Gate area or region which are not protected by photoresist areas. Of course, a Bottom Anti Reflective Coating (BARC) layer (not shown) could be deposited under the photoresist layer to reduce the light reflection and enhance the precision during the photolithographic exposure. Then, in step 114, use the Pad-Nitride layer 206 and the sidewall of the Nitride spacer layer 210 as protection mask, anisotropic etch down the Oxide in the exposed STI region 212 in the Gate region around 60nm from the top of the OSS, and portions of the sidewalls of the Fin Base are revealed. (It is noted that some over-etching of the exposed STI region are desired as the future vertical Gate structure can be made to be deeper than those of both Source and Drain regions).

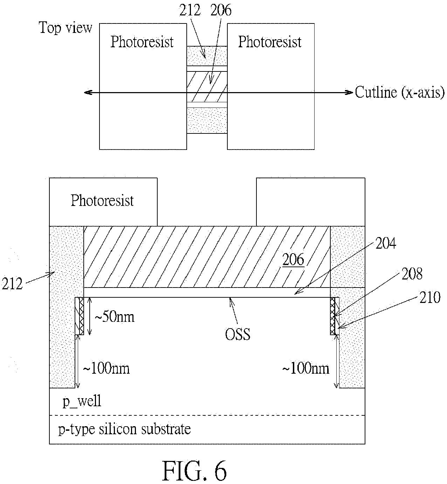

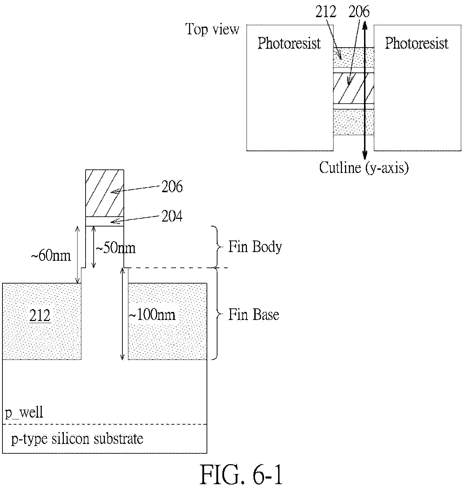

Afterward, in step 116, remove the spacer layer surrounding the Fin Body in the Gate region, such that the sidewalls of the single-crystalline Fin Body are exposed only inside the defined Gate region, as shown in FIG. 6. The cross section view along the Y-direction cutline of this temporary structure is shown in FIG. 6-1. Again, in this step, even the Fin Body in the Gate region is revealed, the remaining of Fin Body extended laterally to two ends of the active region is still protected by the Oxide spacer layer 208, the Nitride spacer layer 210 and the raised STI Oxide 212, so is the Fin Base. Furthermore, the depth of the Fin Body is decided by the first dig-etching process and the depth of the Fin Base is decided by the second dig-etching process, as mentioned in FIG. 4-1.

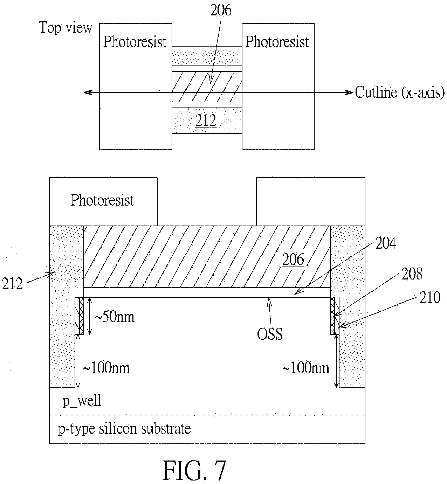

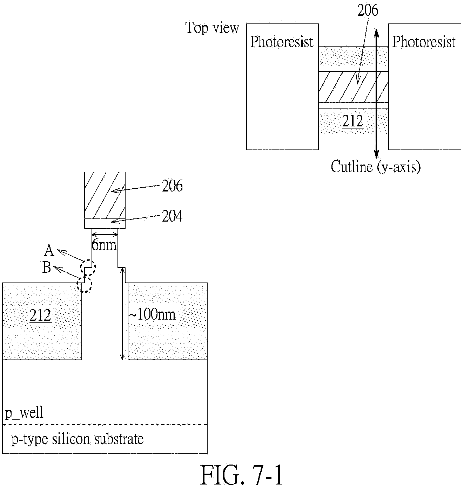

Then, in step 118, use a thinning technique or shaping technique (such as a well designed dry etching technique combining with isotropic etching and anisotropic etching) to precisely thin the width of the Fin Body (and Fin Base) in the Gate region. For example, the original width of the Fin Body is 10-12 nm, the width of the thinned Fin Body in the Gate region could be 6nm, as shown in FIG. 7. The cross section view along the Y-direction cutline of this temporary structure is shown in FIG. 7-1. So the remaining Silicon Fin Body in the Gate areas has the width of around 6nm, and in one embodiment, the Fin Body could be a well-defined rectangular shape with straight sidewalls surrounded by the well designed dry etching technique (so the name RB refers to Rectangular Body). The Fin Body could be thinned by other well designed dry etching technique into other preferable shape, and the dash corner A or dash corner B (shown in FIG. 7-1) in the perpendicular profile of the Fin structure may not be a step transition, but still a non-gradual transition.

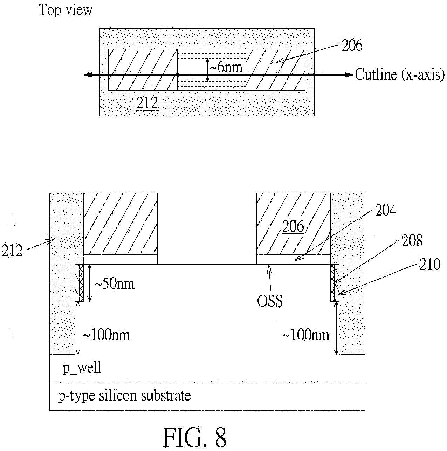

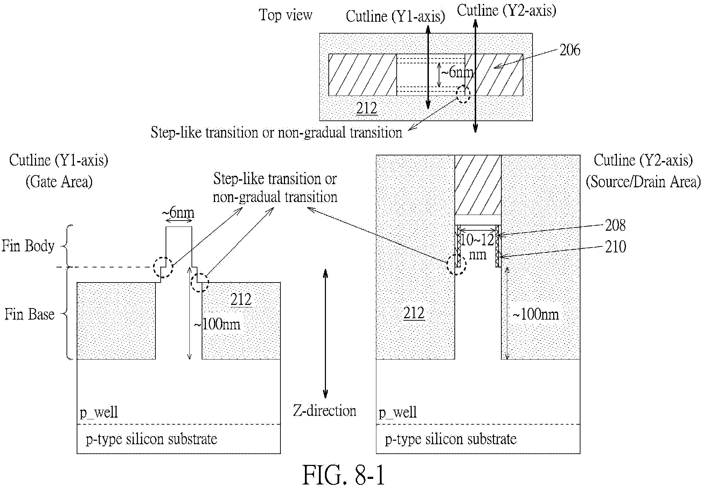

Thereafter, In step 120, remove the exposed Pad-Nitride layer 206 as well as the Nitride spacer layer 210 in the Gate region, and then remove the photoresist, as shown in FIG. 8. The cross section views of this temporary structure along different Y-direction cutlines (Y1-axis for Gate region or area, and Y2-axis for future Source/Drain region or areas) are shown in FIG. 8-1. As shown in FIG. 8-1, between the Fin Body and the Fin Base, a step-like or non-gradual gap is shown. It is noticed that, there could be two step-like or non-gradual transitions in the perpendicular profile of the Fin structure in the Gate region.

Moreover, the Fin Body areas which will be used as the regions for both Source and Drain have the width of the Fin Body to be unchanged without being consumed in the aforesaid well designed dry etching technique, as shown in the bottom right picture of FIG. 8-1. It is noticed that there is one step-like or non-gradual transition in the perpendicular profile of the Fin structure in the Source/Drain region, and there are two step-like or non-gradual transitions in the perpendicular profile of the Fin structure in the Gate region, as shown in FIG. 8-1.

By following this inventive process and structure as described herein, the Fin Body has two separate portions: a narrow one which is used inside the Channel region or Gate area has a narrow Body width (Fin Body as Channel, e.g. 6nm, as shown in bottom left picture of FIG. 8-1) and the other wide one which is used for Source/Drain regions (Fin Body in Source/Drain areas, e.g. 10-12nm, as shown in bottom right picture of FIG. 8-1). The width of the Fin Body in the Channel region or Gate area is controlled by the well-designed dry etching technique. Thus, the lateral profile (along a direction (X-axis) substantially parallel to the original surface OSS) of the invented Fin Body between the defined Gate area and the Source/Drain areas has a step-like transition or non-gradual transition, as marked in the top picture of FIG. 8-1. Moreover, the perpendicular profile (along a direction (Z-axis) substantially perpendicular to the original surface OSS) of the invented Fin structure has a step-like transition or non-gradual transition between the portion of the Fin Body and the Fin Base, as marked in in bottom left picture of FIG. 8-1. Similarly, in this step, even the Fin Body in the Gate area is revealed and thinned, the remaining of Fin Body extended laterally to two ends of the active region is still protected by the Oxide spacer layer 208, the Nitride spacer layer 210 and the raised STI Oxide 212 (so is the Fin Base), and therefore it is hardly to collapse.

The following describes an example to form the Gate structure. In step 122, a Hi-k gate dielectric material 216 or Oxide dielectric material is formed in the defined Gate region, and in step 124, N+ polysilicon 218 (or other conductive material, such as Tungsten) as the Gate conductive material is deposited and then CMP/etch back the deposited N+ polysilicon layer 218. Thereafter, in step 126, deposit a Gate cap layer (such as a composite structure including Nitride cap layer 220 and Hard Mask Oxide (HM_Oxide) layer 222) and then CMP the HM_Oxide layer 222 and the Nitride cap layer 220 such that the top of the HM_Oxide layer 222 is aligned with the Pad-Nitride layer 206, as shown in FIG. 9. The cross section view of this temporary structure along the Y-direction cutline is shown in FIG. 9-1.

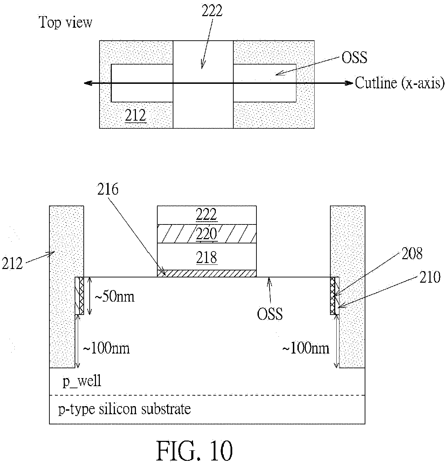

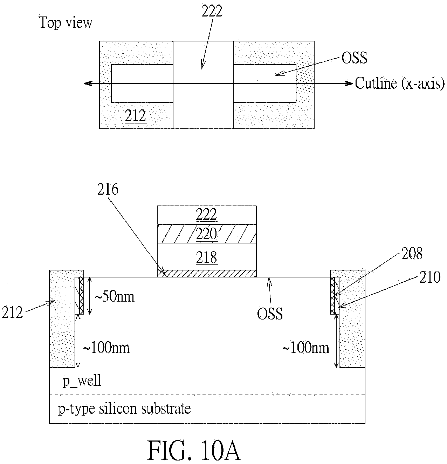

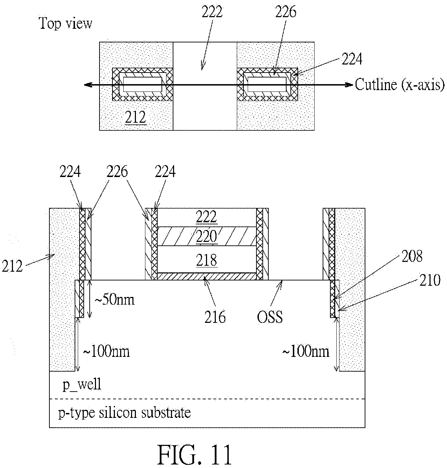

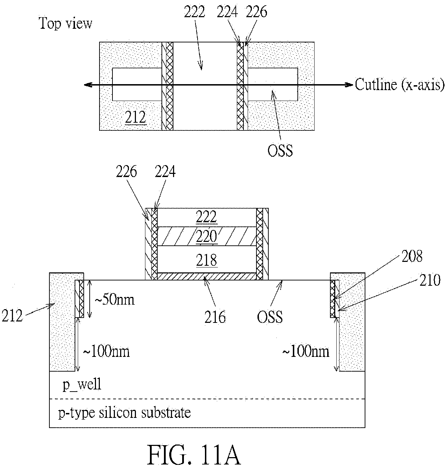

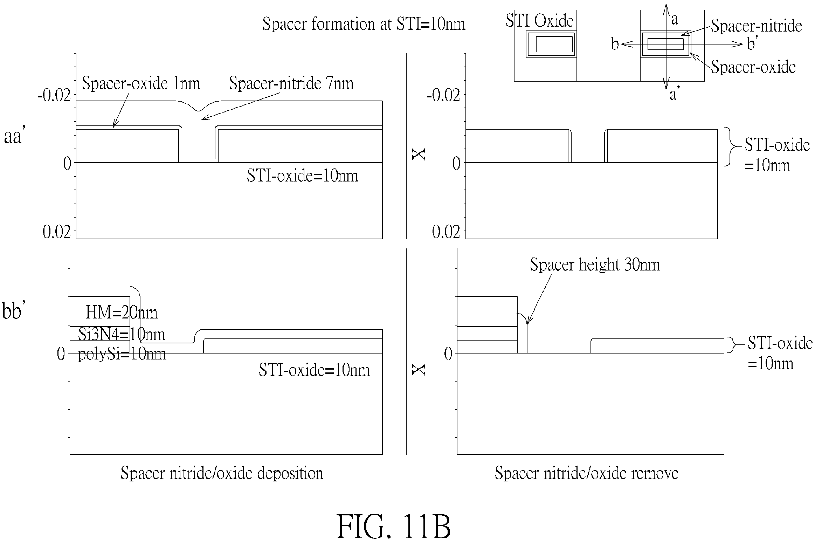

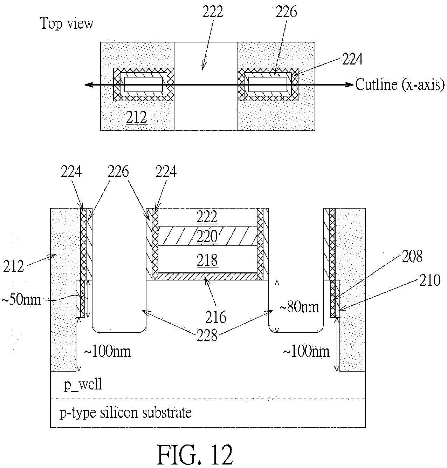

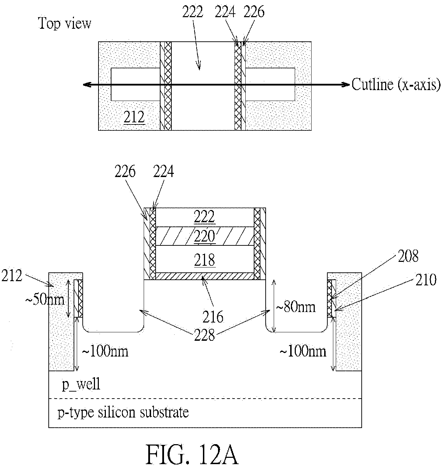

The following describes an example to form the Source/Drain structure. In step 128, etch Pad-Nitride layer 206 and the Pad Oxide layer 204 to reveal the original silicon surface outside the Gate region (FIG. 10), and some STI Oxide 212 and HM_Oxide layer 22 may be removed as well. It is noticed that the top of the STI Oxide 212 is higher than the OSS, and such higher STI region 212 could be helpful to limit the formation of Source/Drain structure by selective growth described later. Then, form an Oxide-2 spacer 224 and a Nitride-2 spacer 226 on the edges of the Gate structure (FIG. 11). It is noticed that, as mentioned in FIG. 8-1, the width of the Fin Body (~9nm) under the Oxide-2 spacer 224 and Nitride-2 spacer 226 (located within the Source/Drain areas) will be larger than the width of the Fin Body (~6nm) under the Gate. Furthermore, in step 130, etch away some exposed Silicon areas to create trenches 228 for source and drain regions, e.g. about 80nm deep (FIG. 12).

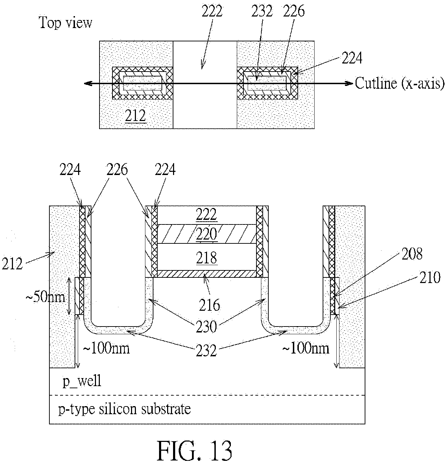

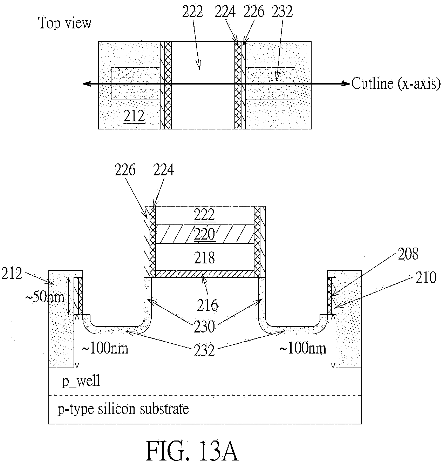

The following describes how to form the source and drain structures in step 132. First, use a thermal oxidation process, called as Oxidation-3, to grow both Oxide-3V layers 230 penetrating the vertical sidewalls of the transistor body (assuming with a sharp crystalline orientation <110>) and Oxide-3B layers 232 on top of the bottoms of both source and drain trenches 218, the Oxidation-3 process grows little Oxide on these walls such that the width of the active Source/Drain regions is not really affected (FIG. 13). Wherein the thickness of the Oxide-3V layer 230 and Oxide-3B layer 232 drawn in FIG. 13 and following figures are only shown for illustration purpose, and its geometry is not proportional to the dimension of the STI-Oxide 212 shown in those figures. For example, the thickness of the Oxide-3V layer 230 and Oxide-3B layer 232 is around 10-20 nm, but the vertical height of the STI-Oxide could be around 150~200 nm. But it is very important to design this Oxidation-3 process such that the thickness of Oxide-3V layer 230 be very accurately controlled under both precisely controlled thermal oxidation temperature, timing and growth rate. Since the thermal oxidation over a well-defined Silicon surface should result in that 40% of the thickness of Oxide-3V layer 230 taken away the thickness of the exposed <110> Silicon surface in the vertical wall of the transistor body and the remaining 60% of the thickness of Oxide-3V layer 230 be counted as an addition outside the vertical wall of the transistor body.

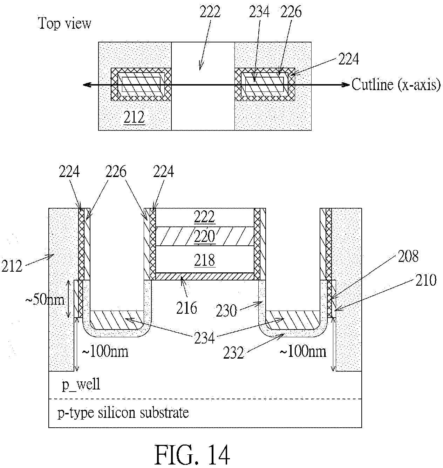

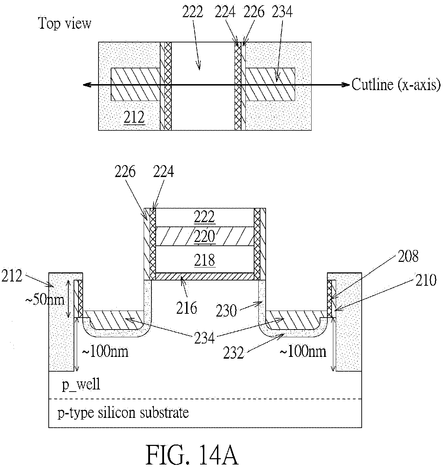

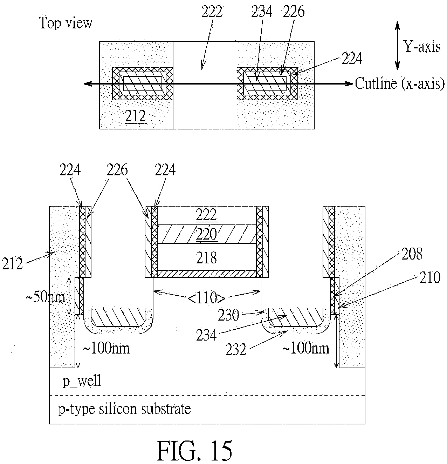

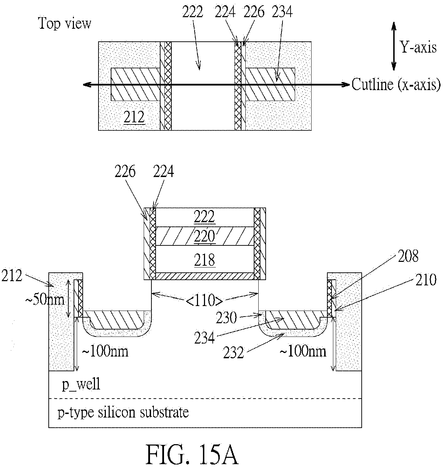

Thereafter, as shown in FIG. 14, use CVD Nitride deposition and then etching back to form a Nitride layer 234 on the top of the Oxide-3B layer 232. (In another example, it is optional to further deposit Tungsten and etch back to form a Tungsten layer on the top of the CVD deposited Nitride layer 234. Then deposit TiN layer and etch back to form the TiN layer above the Tungsten layer, such that the top of the TiN layer is lower than OSS around 20-40nm.) Then, as shown in FIG. 15, carry out an etching process to etch the thermal Oxide-3, especially the Oxide-3V layer 230, to reveal the crystalline orientation <110> of the Silicon region. As shown in FIG. 15, there is a Partial Isolation with L-shape Isolators (including: (1)L-shape Oxide-3 which comprises Oxide-3V layer 230 close to the Silicon area which is under the Gate structure and the Oxide-3B layer 23,2 and (2) the Nitride layer 234) under the Source/Drain region, and such Partial Isolation with L-shape Isolators could be abbreviated as PILI.

It is noticed that, in one embodiment, the width of the revealed crystalline orientation <110> Silicon along Y-direction could be around 10~12nm which is larger than the width (~6nm) of the Fin Body under the Gate.

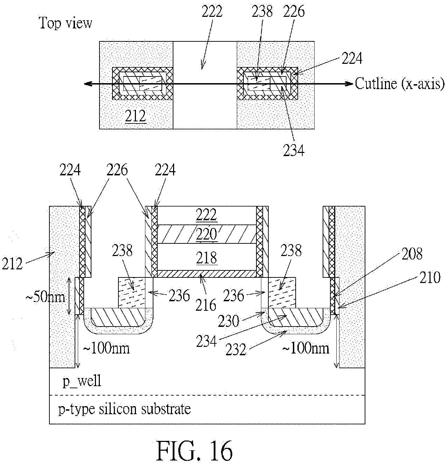

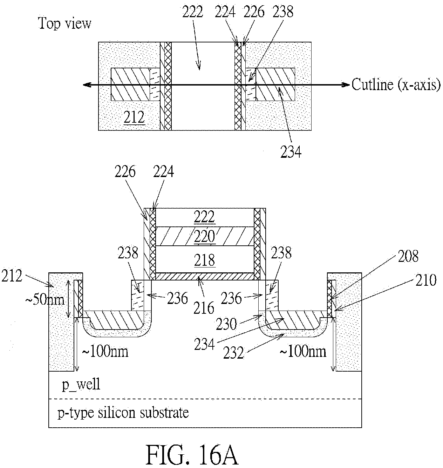

Afterward, as shown in FIG. 16, use a selective growth technique (such as selective epitaxy growth) to form an n-type LDD (Lightly Doped Drain) region 236 and then n+ Doped Source and Drain regions 238, respectively from the revealed crystalline orientation <110> of the Silicon region. It is possible to anneal the grown n-type LDD 236 and/or n+ Doped Source and Drain regions 238, such that the interface between the LDD 236 and the p-type substrate material is close to the narrower Channel region. To be mentioned, no ion-implantations for forming all Channel, Drain and Source regions are needed, and no high temperature and long thermal annealing is required to remove those damages due to heavy bombardments of forming these regions. Furthermore, since the top of the STI Oxide 212 is higher than the OSS, the selectively grown n-type LDD 236 and n+ Doped Source and Drain regions 238 are limited by the higher STI regions 212 without growing over the STI regions 212 and have the well-grown <110> crystalline Silicon structure.

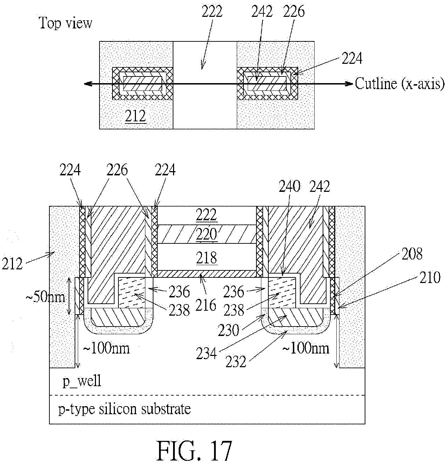

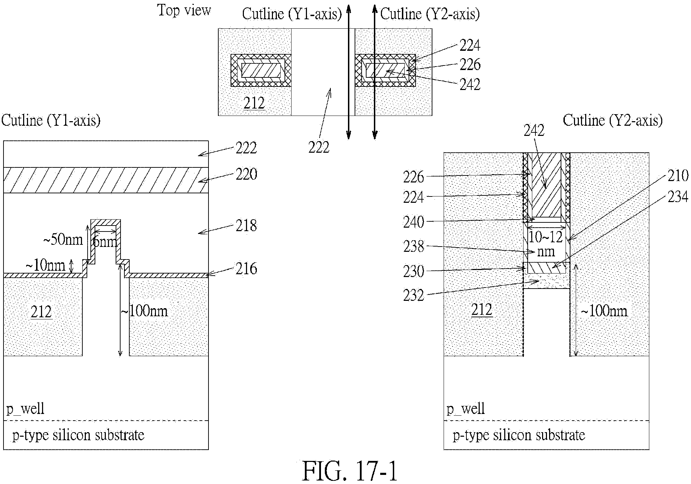

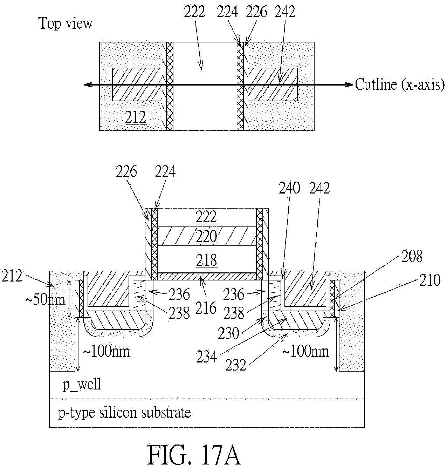

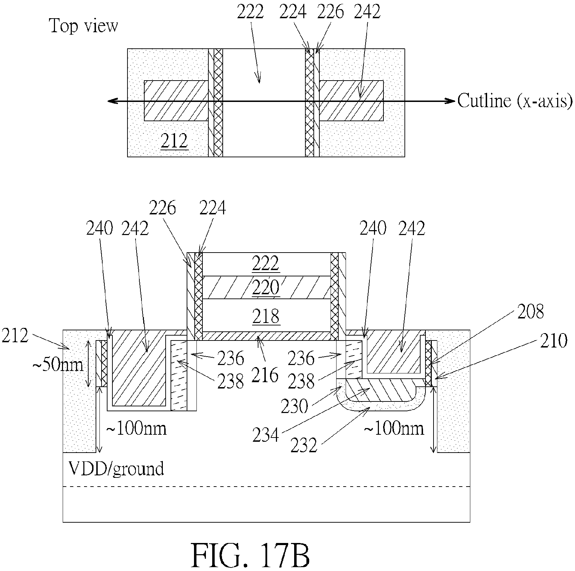

Finally, deposit a TiN layer 240 and then a Tungsten layer 242 to fill in the Source/Drain trenches (FIG. 17). Up to now, the height of the n+ Doped Source and Drain 238 is around 40-50nm, and the n+ Doped Source and Drain are surrounded by the TiN layer 240 and Tungsten layers 242 at least two sides (top side and one sidewall), so the contact resistance is dramatically reduced. The Tungsten layer 242 not only fills in the trenches under the OSS, but also fills in the trenches above the OSS which is surrounded by the STI region 212.

Furthermore, since the STI region 212 corresponding to the Gate areas is etched down around 60-80nm from the top of the OSS, the bottom of the gate structure (over the STI region) could be lower than the bottom of the n+ Doped Source and Drain around 10-20nm, such that the loff could be reduced as well. The cross section views of the invented FinFET structure along different Y-direction cutlines (Y1-axis for Gate region and Y2-axis for Source/Drain regions) are shown in FIG. 17-1, it is clear that the Fin Body inside Gate region has a narrower width (e.g. 6nm, as shown in bottom left picture of FIG. 17-1) and the n+ Doped Source/Drain regions 238 have a wider width (e.g. 10-12nm, as shown in bottom right picture of FIG. 17-1). Since the width of the heavily Doped Source/Drain regions 238 is wider than that of the Fin Body inside Gate region, the resistance of the Source/Drain regions could be controlled within an acceptable range, and the wider Source/Drain regions is helpful for metal contact as well.

In the previous embodiment, the Oxide-2 spacer 224 and the Nitride-2 spacer 226 surrounding the sidewall of the STI-Oxide 212 in FIG. 11 may occupies portion of the revealed Silicon area shown in FIG. 10, and it may reduce the area of the trenches 228 created in FIG. 12. Thus, the following introduces another embodiment of the present invention to form the Source/Drain structure to avoid the above-mentioned issue.

Similarly in step 128, etch Pad-Nitride layer 206 and the Pad Oxide layer 204 to reveal the original silicon surface outside the Gate region, and most STI Oxide 212 will be removed as well, such that the top of the STI Oxide 212 is just a little bit higher than the OSS, as shown in FIG. 10A. Such higher STI region 212 could be a fence and is still helpful to limit or confine the formation of Source/Drain structure by selective growth described later. Then, form an Oxide-2 spacer 224 and a Nitride-2 spacer 226 on the edges of the Gate structure, but the Oxide-2 spacer 224 and the Nitride-2 spacer 226 over the STI Oxide 212 and the OSS are all removed, as shown in FIG. 11A. FIG. 11B is a simulation result to form the spacer on the edge of the Gate structure, wherein the height of the Gate structure is 40nm (including 10nm Poly-Silicon, 10nm Si3N4, and 20nm HM-Oxide) and the height of the STI-Oxide surrounding the Source/Drain region is 10nm. The left top figure in FIG. 11B is the aa' cross section view when a 1nm spacer-Oxide and 7nm spacer-Nitride are formed, and the left bottom figure in FIG. 11B is the bb' cross section view when the 1nm spacer-Oxide and 7nm spacer-Nitride are formed. After the spacer-Oxide and the spacer-Nitride are etched and removed, it is shown that around 30nm height of the spacer-Oxide and the spacer-Nitride are still left on the sidewall of the Gate structure after the spacer-Oxide and the spacer-Nitride are etched (the right bottom figure of FIG. 11B which is the bb' cross section view). Thus, the higher STI region 212 (8~10nm higher than OSS) surrounding the Source/Drain could be helpful to prevent from the existence of the gate spacers on the edge of the higher STI region 212.

At this moment, most of the revealed Silicon area shown in FIG. 10A is still unblock, except those under the Oxide-2 spacer 224 and the Nitride-2 spacer 226 on the edges of the Gate structure. Furthermore, etch away the unblock Silicon areas in FIG. 11A to create trenches 228 for source and drain regions, e.g. about 80nm deep (FIG. 12A).

Thereafter, grow both Oxide-3V layers 230 and Oxide-3B layers 232 in both source and drain trenches 218 (FIG. 13A). Again, the thickness of Oxide-3V layer 230 could be very accurately controlled under both precise thermal oxidation temperature, timing and growth rate. Afterward, as shown in FIG. 14A, use CVD Nitride deposition and then etch back to form a Nitride layer 234 on the top of the Oxide-3B layer 232. Then, as shown in FIG. 15A, carry out an etching process to etch the grown thermal Oxide in the trenches 218, especially the Oxide-3V layer 230, to reveal the crystalline orientation <110> of the Silicon region. Thus, the edge of the revealed crystalline orientation <110> Silicon is well-controlled. It could be aligned with the edge of the Gate structure, under the Gate structure, or under the spacers (that is, the Oxide-2 spacer 224 and the Nitride-2 spacer 226) which covers the sidewalls of the Gate structure.

Afterward, as shown in FIG. 16A, use a selective growth technique (such as selective epitaxy growth) to form an n-type LDD (Lightly Doped Drain) region 236 and then n+ Doped Source and Drain regions 238, respectively from the revealed crystalline orientation <110> of the Silicon region. It is possible to anneal the grown n-type LDD 236 and/or n+ Doped Source and Drain regions 238. Furthermore, since the top of the STI Oxide 212 is still higher than the OSS, the selectively grown n-type LDD 236 and n+ Doped Source and Drain regions 238 could be limited by the higher STI regions 212. Finally, deposit a TiN layer 240 and then a Tungsten layer 242 to fill in the Source/Drain trenches 228(FIG. 17A). In another embodiment, as shown in FIG. 17B, it is possible that only one of the Drain structure and Source structure has PILI (Partial Isolation with L-shape Isolators) thereunder, but the other does not have PILI and the TiN layer 240 and the Tungsten layer 242 are directly contacted to the substrate which could be supplied with VDD, Ground voltage, or other preferable voltage.

Although in the previous embodiments, the gate structure is firstly formed before the formation of Source/Drain regions, it is well-known that the "Gate-Last" process can be performed in the present invention without difficulties and no needed to elaborate here.

In summary, a 3D transistor Structure with precise geometries is disclosed. The Fin Body could be solid and not easily bent as the dimension is getting narrower due to scaling. Furthermore, the new 3D FET structure can have a smaller Fin Pitch since the Source/Drain regions are well-confined during the formation, thus reducing the area of the transistor so as to getting closer to meet the demands from the Moore's Law of more transistors per unit area and lower cost per transistor. The contact resistance of the Source/Drain regions with the metal plug is lower as well since the n+ Doped Source and Drain are surrounded by the Tungsten layers at least three sides. Moreover, the perpendicular profile (Z-direction) of the invented Fin structure has a step-like transition or non-gradual transition, and the Fin Body region could be a rectangular shape or other desired shape. The width of the Fin Body in the Channel region or Gate area is well-controlled by the aforesaid Fin thinning process, thus, inside the Channel region there is a narrow Body width (Fin Body as Channel, e.g. 6nm) and the other wide one which is reserved for Source/Drain regions (Fin Body as S/D, e.g. 9nm). Therefore, the lateral profile (X-direction) of the invented Fin Body has a step-like transition or non-gradual transition as well.

Compared with the conventional FinFET structure, the proposed FinFET structure according to the present invention has following advantages:
(1) The shape and dimension of the Fin Body in the conventional FinFET structure is difficult to controlled. However, the dimension and the shape of the Fin Body in the Gate region are well-controlled. The width of the Fin Body in the Gate region is well-controlled (e.g., the width of the Fin Body could be easily controlled within 3-6nm even the technology node is 9-12 nm), the depth of the Fin Body in the Gate region is easily controlled as well by first dig-etching process mentioned in FIG. 4-1. Thus, the Fin Body of the present invention in the Gate region could be a rectangle-like shape or other preferable shape.
(2) The Fin structure in the conventional FinFET structure is easily collapsed, especially when the technology node is down to 10nm or lower. Nevertheless, in the present invention, the Fin Body and the Fin Based are formed or defined by separate etching steps, and even the Fin Body in the Gate area is thinned, the remaining of Fin Body extended laterally to two ends of the active region is still protected by the Oxide Spacer layer OS-1, the Nitride-Spacer Ns-1 and the STI Oxide, therefore it is hardly to collapse. Moreover, the Fin Base under the Fin Body is fully surrounded by the STI Oxide such that the Fin Base is a solid base.
(3) The crystalline structure and the dimension of the Source/Drain of the conventional FinFET (no matter by ion implantation or selective growth) is difficult to controlled. On the other hand, in the present invention, the n-type LDD and n+ Doped Source and Drain regions are only selectively grown based on <110> crystalline structure. Furthermore, since the top of the STI Oxide is higher than the OSS, the selectively grown n-type LDD and n+ Doped Source and Drain regions could be limited or confined by the higher STI Oxide regions without growing over the STI Oxide regions. In the present invention, since the width of the Source/Drain regions is wider than that of the Fin Body inside Gate region, the resistance of the Source/Drain regions could be controlled within an acceptable range, and the wider Source/Drain regions is helpful for metal contact as well.

## Claims

1. A semiconductor transistor comprising:
a semiconductor substrate with an original surface;
an active region formed based on the semiconductor substrate, the active region having a fin structure;
a shallow trench isolation region surrounding the active region;
a gate structure of the transistor crossing over the fin structure;
a first conductive structure and a second conductive structure of the transistor;
a spacer contacted to a sidewall of the gate structure and over the fin structure;
**characterized by**:
wherein a width of the fin structure under the spacer is wider than that of the fin structure under the gate structure, or the fin structure has a perpendicular profile along a direction substantially perpendicular to the original surface, wherein the perpendicular profile of the fin structure provides a first non-gradual transition or step-like transition.

2. The semiconductor transistor of claim 1, further **characterized in that** the first conductive structure is limited by the shallow trench isolation region, and a width of the first conductive structure is wider than that of the fin structure under the gate structure.

3. The semiconductor transistor of claim 1, further **characterized in that** the fin structure comprises a fin body and a fin base, the fin structure has a perpendicular profile along a direction substantially perpendicular to the original surface, and the perpendicular profile comprises a step-like transition between the fin body and the fin base.

4. The semiconductor transistor of claim 3, further **characterized in that** the fin structure has a lateral profile along a direction substantially parallel to the original surface, wherein the lateral profile of the fin structure provides another step-like transition.

5. The semiconductor transistor of claim 1, further **characterized in that** the first conductive structure is contacted to a first end of the fin structure, the second conductive structure is contacted to a second end of the fin structure, and the first conductive structure and the second conductive structure are independent from the Fin structure.

6. The semiconductor transistor of claim 1, further **characterized in that** a bottom of the gate structure over the shallow trench isolation region is lower than that of the first conductive structure and/or the second conductive structure.

7. The semiconductor transistor of claim 1, further **characterized in that** at least two sides of the first conductive structure or the second conductive structure are contacted to a metal-containing region.

8. The semiconductor transistor of claim 1, further **characterized in that** the fin structure comprises a fin body covered by the gate structure and a fin base portion of which is not covered by the gate structure, and the first non-gradual transition or step-like transition is between the fin body and the fin base.

9. The semiconductor transistor of claim 1, further **characterized in that** a top surface of a portion of the shallow trench isolation region covered by the gate structure is lower than that of other portion of the shallow trench isolation region not covered by the gate structure.

10. The semiconductor transistor of claim 1, further **characterized in that** the fin structure has a lateral profile along a direction substantially along to the original surface, wherein the lateral profile of the fin structure provides a second non-gradual transition or step-like transition.

11. The semiconductor transistor of claim 10, further **characterized in that** the second non-gradual transition or step-like transition is between the gate structure and the first conductive structure.

12. The semiconductor transistor of claim 11, further **characterized in that** the lateral profile of the fin structure further provides a third non-gradual transition or step-like transition which is between the gate structure and the second conductive structure.

13. The semiconductor transistor of claim 1, further **characterized in that** the first conductive structure and/or the second conductive structure is limited by the shallow trench isolation region.

14. The semiconductor transistor of claim 13, further **characterized in that** the first conductive structure is contacted to a first end of the fin structure, the second conductive structure is contacted to a second end of the fin structure, and the first conductive structure and the second conductive structure are independent from the fin structure.

15. The semiconductor transistor of claim 1, further **characterized in that** a bottom of the gate structure over the shallow trench isolation region is lower than that of the first conductive structure and/or the second conductive structure.

16. The semiconductor transistor of claim 1, further **characterized in that** at least two sides of the first conductive structure are contacted to a metal-containing region.

17. The semiconductor transistor of claim 1, further **characterized in that** the perpendicular profile of the fin structure covered by the gate structure comprises two non-gradual transition or step-like transition.
